# EUROPÄISCHE PATENTANMELDUNG

(11) **EP 2 444 878 A2**
(43) Veröffentlichungstag der Anmeldung: **25.04.2012**
(21) Anmeldenummer: 11180887.9
(22) Anmeldetag: 12.09.2011
(51) Int. Cl.: G06F 3/033, G06F 3/042, G06F 3/044

(54) **Eingabevorrichtung zur Steuerung eines elektronischen Geräts**

(30) Priorität: 20.10.2010 DE 102010042690
(71) Anmelder: Bayerische Motoren Werke Aktiengesellschaft, 80809 München (DE)
(72) Erfinder: Küdde, Peter, 85586 Poing (DE); Dr.-Ing.Schmidt, Harald, 82205 Gilching (DE)
(74) Vertreter: Bücken, Helmut

(57) **Zusammenfassung**

Die Erfindung beschreibt eine Eingabevorrichtung (1) zur Steuerung eines elektronischen Geräts mit einem Touch-Panel (11) als zumindest ein Eingabemittel (10). Die erfindungsgemäße Eingabevorrichtung zeichnet sich dadurch aus, dass das Touch-Panel (11) eine keramische Oberfläche aufweist.

## Beschreibung

Die Erfindung betrifft eine Eingabevorrichtung zur Steuerung eines elektronischen Geräts mit einem Touch-Panel als zumindest ein Eingabemittel.

In Kraftfahrzeugen werden Infotainmentsysteme über eine als zentrale Bedieneinheit bezeichnete Eingabevorrichtung bedient. Ein Infotainmentsystem im Automobilbereich ist ein System von Komponenten, welches verschiedene Funktionen im Bereich Komfort oder Sicherheit bereitstellt. Die wesentlichen Bereiche sind hierbei Navigation, Kommunikation, Multimedia sowie Fahrerassistenzsysteme. Die Bedienung des Infotainmentsystems erfolgt häufig über einen Dreh-Drück-(Schiebe)-Steller und/oder Tasten sowie, optional, Spracheingabe für wichtige Funktionen von Mobiltelefon, Navigation, Audio, Video und Fahrzeug. Die Bedienelemente (Dreh-Drück-(Schiebe)-Steller und/oder Tasten) sind meist räumlich von einer Anzeigeeinheit des Infotainmentsystems abgesetzt. Die Bedienelemente sind für eine vereinfachte Bedienung in der Konsole auf dem Fahrzeugmitteltunnel angeordnet. Diese Trennung ermöglicht es, den Bildschirm in einen günstigen Bereich nahe der Frontscheibe anzuordnen und die Bedienelemente in einem leicht erreichbaren Greifraum zu positionieren.

Insbesondere bei der Bedienung des Mobiltelefons und der Navigation sind nicht nur in dem Infotainmentsystem gespeicherte Funktionen oder Inhalte auszuwählen, sondern auch Texte, wie z.B. Adressen oder Namen, in das Infotainmentsystem einzugeben. Auch die zunehmend aufkommende Möglichkeit, das Internet aus einem Kraftfahrzeug heraus zu benutzen, erfordert die Möglichkeit, Worte oder Wortfolgen auf einfache Weise eingeben zu können. Die üblicherweise in einem Kraftfahrzeug vorgesehenen Bedienelemente, wie der eingangs erwähnte Dreh-Drück-(Schiebe)-Steller und/oder vordefinierte Tasten, lassen die Eingabe von Informationen oftmals nicht mit dem gewünschten Komfort zu.

Im Bereich von Computern, insbesondere von Notebooks und Netbook-Rechnern, sowie einer Vielzahl von Mobiltelefonen sind sog. Touch-Panels anzutreffen. Über Touch-Panels kann durch Berührung mit einem speziellen Eingabegerät oder einem Finger eine Steuerung des elektronischen Geräts erfolgen. Im Bereich von Notebooks und Netbook-Rechnern sind die Touch-Panels aus Kostengründen meist mit einer Oberfläche aus Kunststoff ausgestattet. Teilweise sind auch Oberflächen aus Glas anzutreffen, um eine erhöhte Festigkeit des Touch-Panels, eine bessere Materialausnutzung und Dauerhaftigkeit zu erzielen. Nachteilig bei der Verwendung von Kunststoffoberflächen ist, dass diese im Laufe der Zeit Abnutzungsspuren aufweisen, welche nur durch einen vollständigen Austausch des kompletten Touch-Panels behoben werden können. Oberflächen aus Glas weisen demgegenüber den Vorteil einer härteren Oberfläche auf. Allerdings kann die Glasoberfläche bei der Berührung mit scharfkantigen Gegenständen leicht zerkratzen, wodurch das Erscheinungsbild ebenfalls leidet. Unter Umständen kann sogar eine Beeinträchtigung der Funktionsfähigkeit die Folge sein.

Insbesondere im Bereich von Mobilfunkgeräten sind Touch-Panels auch als Touch-Screens (sog. Sensorbildschirme) ausgebildet. Diese stellen ein Computereingabegerät dar, bei dem durch Berührung von Teilen eines auf dem Touch-Screen dargestellten Bildes der Programmablauf des technischen Geräts direkt gesteuert werden kann. Hierbei wird der Eindruck einer unmittelbaren Steuerung des technischen Geräts per Fingerzeig erzeugt. Solche Touch-Screens können auf resistiver, kapazitiver, optischer oder induktiver Technologie basieren.

Auch im Bereich von Kraftfahrzeugen ist zur Steuerung des Infotainmentsystems daran gedacht, die zentrale Bedieneinheit um ein Touch-Panel als weiteres Eingabemittel zu erweitern. Da die Lebensdauer eines Kraftfahrzeugs jedoch ungleich höher ist als die Lebensdauer eines Computers oder Mobilfunkgeräts, muss das Touch-Panel derart beschaffen sein, dass dieses auch nach langjähriger Benutzung fehlerfrei arbeitet und den optischen Ansprüchen an die Anmutung ohne sichtbare Verschleißerscheinungen genügt.

Es ist daher Aufgabe der vorliegenden Erfindung, eine Eingabevorrichtung anzugeben, welche auf Berührung basiert und eine dauerhafte Funktionsfähigkeit und Optik bereitstellt.

Diese Aufgabe wird durch eine Eingabevorrichtung gemäß den Merkmalen des Patentanspruches 1 gelöst. Vorteilhafte Ausgestaltungen ergeben sich aus den abhängigen Patentansprüchen.

Die Erfindung schafft eine Eingabevorrichtung zur Steuerung eines elektronischen Geräts mit einem Touch-Panel als zumindest ein Eingabemittel. Erfindungsgemäß weist das Touch-Panel eine keramische Oberfläche auf.

Die keramische Oberfläche des Touch-Panels stellt auch bei einer intensiven und langjährigen Nutzung unter extremen Witterungsbedingungen (Kälte, Sonne, Hitze usw.) sicher, dass sowohl die Funktionsfähigkeit als auch die Optik den hohen Anforderungen genügen, wie diese insbesondere im Umfeld von Kraftfahrzeugen gegeben sind. Gegenüber einer Kunststoff- oder Glasoberfläche weist eine keramische Oberfläche eine erhöhte Festigkeit und Materialhärte auf. Aufgrund der Materialeigenschaften sind diese sowohl gegenüber dauerhafter, insbesondere langjähriger, bestimmungsgemäßer Benutzung durch Berührung sowie gegenüber auf die Oberfläche einwirkende Gegenstände gegen Abrieb und Abnutzung resistent. Dennoch kann der von bekannten Touch-Panels gewohnte Bedienkomfort, d.h. das Ansprechen auf eine Berührung, bei Verwendung einer keramischen Oberfläche sichergestellt werden.

Das Touch-Panel der erfindungsgemäßen Eingabevorrichtung zeichnet sich weiterhin dadurch aus, dass dieses keine Anzeigefähigkeit besitzt. Im Gegensatz zu den aus dem Bereich von Mobiltelefonen bekannten Touch-Panels bzw. -Screens braucht das Touch-Panel keine Informationen darstellen, da diese über ein zentrales Display des Infotainmentsystems dargestellt werden. Vielmehr ist es ausreichend, wenn über das Touch-Panel, wie bei Computern, eine Steuerung des elektronischen Geräts erfolgen kann. Je nach Ausgestaltung der dem Touch-Panel zugeordneten Recheneinheit kann es möglich sein, über das Touch-Panel einfache und komplexe Schriftzeichen lateinischer oder asiatischer Schrift sowie Ziffern einzugeben. Zusätzlich sind die Eingabe von Gesten, auch mit mehreren Fingern möglich.

Eine besonders einfache Fertigung der Eingabevorrichtung ergibt sich dann, wenn die keramische Oberfläche des Touch-Panels durch eine keramische Folie gebildet ist. Keramische Folien können in unterschiedlichen Stärken und Formen hergestellt werden. Die Verwendung einer keramischen Folie ermöglicht die Integration des als keramische Oberfläche ausgebildeten Touch-Panels in eine Eingabevorrichtung, wie beispielsweise eine zentrale Bedieneinheit eines Infotainmentsystems eines Kraftfahrzeugs, auf einfache und kostengünstige Weise. Ein besonderer Vorteil einer keramischen Folie besteht darin, dass diese vor dem Brennvorgang in eine gewünschte Form gebracht werden kann, so dass die Anpassung an die Gegebenheiten der Eingabevorrichtung erleichtert sind.

Es ist weiterhin zweckmäßig, wenn die keramische Folie, insbesondere direkt, auf eine auf Berührung empfindliche Sensorfolie einer Trägereinheit aufgebracht ist. Die Sensorfolie kann wahlweise auf einem kapazitiven Prinzip oder einem optischen Prinzip basieren. Die auf Berührung empfindliche Sensorfolie kann beispielsweise auf dem Prinzip der bekannten ITO-Folien zur Sensierung von berührenden Bewegungen basieren. Derartige ITO-Folien sind beispielsweise von den Displays von Mobiltelefonen des Herstellers Apple bekannt. Bei einem kapazitiven Arbeitsprinzip kann die Keramik hinsichtlich der Transmissionseigenschaften beliebig sein. Im Falle eines optischen Arbeitsprinzips muss die Keramik so gewählt sein, dass diese für Infrarotstrahlen durchlässig ist.

Alternativ ist auf die Rückseite der keramischen Folie eine elektrisch leitende Struktur direkt aufgebracht, welche gemäß vorgegebener, sensorischer Anforderungen durch ein subtraktives Verfahren erzeugt ist. Unter der Rückseite der keramischen Folie wird die der Berührseite abgewandte Seite der keramischen Folie verstanden. Beispielsweise kann eine Beschichtung der Rückseite der keramischen Folie mittels eines PVD (Physical Vapour Deposition)-Prozesses erfolgen. Durch diesen wird zunächst eine vollflächige leitende Struktur aufgebracht, welche anschließend über ein subtraktives Verfahren, beispielsweise unter Verwendung eines Lasers, entsprechend den sensorischen Anforderungen ausgespart wird.

Gemäß einer weiteren zweckmäßigen Ausgestaltung weist die keramische Oberfläche eine Wölbung auf. Wie erläutert, ist die keramische Folie vor dem Brennvorgang noch verformbar, so dass die gewünschte Gestalt der keramischen Oberfläche hergestellt werden kann. Die Wölbung der keramischen Oberfläche ermöglicht die Integration dieses Eingabemittels in die Eingabevorrichtung auch unter Berücksichtigung gestalterischer Aspekte, ohne dass die keramische Oberfläche als herkömmliches Touch-Panel sofort ersichtlich wäre.

Es ist weiterhin zweckmäßig, wenn die keramische Oberfläche entlang ihres Außenumfangs zumindest abschnittsweise kreisförmig ist. Es ist besonders bevorzugt, wenn die keramische Oberfläche entlang ihres Außenumfangs die Gestalt eines Kreises aufweist. Bei dieser Ausgestaltung ist während des Brennvorganges sichergestellt, dass die Schrumpfung des keramischen Ausgangsmaterials gleichmäßig erfolgt, so dass die keramische Oberfläche nach dem Brennvorgang aufgrund von Schrumpfung die erwünschte, zumindest abschnittsweise kreisförmige Gestalt aufweist.

Eine Dicke zwischen 0,3 mm und 1,0 mm der keramischen Oberfläche stellt sicher, dass die Berührung durch die auf der Rückseite der keramischen Oberfläche ausgebildeten Sensoren problemlos möglich ist.

Eine weitere Ausgestaltung sieht vor, dass die keramische Oberfläche die unmittelbare Berührfläche ist. Mit anderen Worten bedeutet dies, dass die keramische Oberfläche mit keinen weiteren Oberflächenbeschichtungen versehen ist. Hierdurch kann der Herstellungsaufwand zur Bereitstellung eines dauerhaften Touch-Panels reduziert werden, im Vergleich zu herkömmlichen Touch-Panels mit einer Kunststoffoberfläche.

Gemäß einer weiteren Ausgestaltung ist die keramische Oberfläche einer mechanischen Oberflächenbehandlung, insbesondere einem Läpp-, Strahl- oder Schleifprozess oder einer Laser-Ablation, unterzogen. Die mechanische Oberflächenbehandlung der keramischen Oberfläche ermöglicht es, gestalterische Elemente vorzusehen, die beispielsweise einer verbesserten Haptik und/oder Oberflächenausnutzung des Touch-Panels dienlich sein können.

Die keramische Oberfläche ist vorzugsweise aus dem Hauptbestandteil Zirkonoxid oder Aluminiumoxid gebildet. Prinzipiell kommen jedoch auch andere keramische Materialien zur Ausgestaltung der keramischen Oberfläche des Touch-Panels in Betracht. Die beiden genannten Materialien bieten eine hohe Dauerhaftigkeit bei akzeptablen Kosten und sind somit für die Anwendung in einem Massenprodukt, wie zentralen Bedieneinheiten in Kraftfahrzeugen, besonders geeignet.

In einer weiteren Ausgestaltung ist das Touch-Panel ein Eingabemittel einer zentralen Bedieneinheit eines Kraftfahrzeugs, das insbesondere als weitere Eingabemittel Tasten und/oder einen Dreh-Drück-(Schiebe)-Steller umfasst. Das in Klammer stehende Wort "Schiebe" soll zum Ausdruck bringen, dass die Schiebe-Funktion des Stellers lediglich optionaler Natur ist. Besonders bevorzugt ist es, wenn das Touch-Panel auf dem Dreh-Drück-(Schiebe)-Steller ausgebildet ist. In diesem Fall ist es nicht erforderlich, die als zentrale Bedieneinheit bezeichnete Eingabevorrichtung grundsätzlich neu zu designen. Stattdessen ist es ausreichend, die für das Touch-Panel vorgesehene Fläche ausreichend groß zu gestalten, so dass diese zur Eingabe von Informationen durch Berührung verwendet werden kann. Darüber hinaus ist es möglich, den Dreh-Drück-(Schiebe)-Steller der Eingabevorrichtung durch die keramische Oberfläche optisch ansprechend zu gestalten.

Die Erfindung wird nachfolgend näher anhand von Ausführungsbeispielen in der Zeichnung erläutert. Es zeigen:
- Fig. 1: eine schematische Darstellung einer erfindungsgemäßen Eingabevorrichtung,
- Fig. 2: eine erste Ausführungsvariante eines eine keramische Oberfläche aufweisenden Touch-Panels, und
- Fig. 3: eine zweite Ausführungsvariante eines eine keramische Oberfläche aufweisenden Touch-Panels.

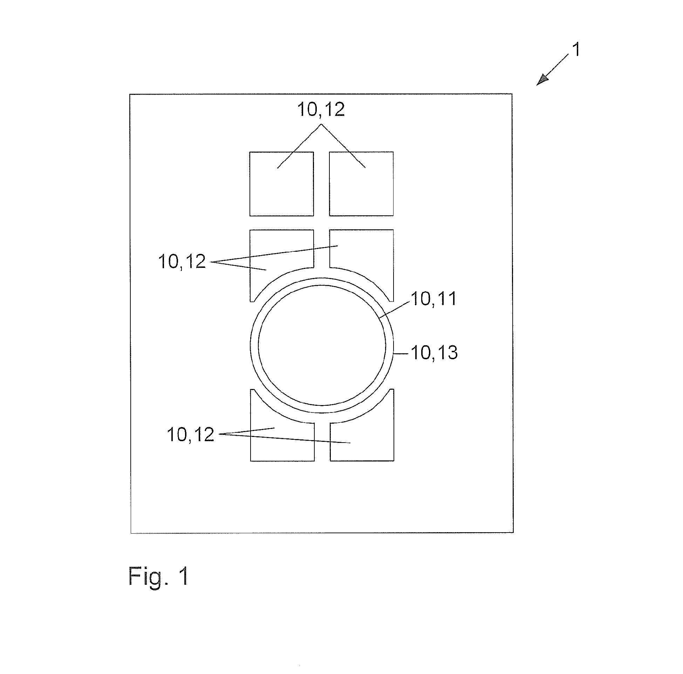

Fig. 1 zeigt eine erfindungsgemäße Eingabevorrichtung 1 zur Steuerung eines nicht näher dargestellten elektronischen Geräts. Die Eingabeeinrichtung 1 ist beispielhaft in Gestalt einer zentralen Bedieneinheit (ZBE) zur Steuerung eines Infotainmentsystems eines Kraftfahrzeugs ausgebildet. Prinzipiell könnte die Eingabevorrichtung 1 auch zur Steuerung anderer elektronischer Geräte, wie z.B. der Unterhaltungselektronik und dergleichen, dienen.

Die Eingabevorrichtung 1 weist beispielhaft als Eingabemittel 10 um einen Dreh-Drück-(Schiebe)-Steller 13 gruppierte Tasten 12 sowie ein auf dem Dreh-Drück-(Schiebe)-Steller angeordnetes Touch-Panel 11 auf. Über den Dreh-Drück-(Schiebe)-Steller 13 ist in einer dem Fachmann bekannten Weise die Navigation durch ein auf einem Bildschirm dargestellten Menü möglich. Durch Drehen und optional Schieben kann ein bestimmter Menüeintrag angewählt, durch Drücken des Dreh-Drück-(Schiebe)-Stellers 13 der hervorgehobene Eintrag gewählt werden. Den Tasten 12 sind beispielsweise vordefinierte Funktionen zugeordnet. So kann beispielsweise durch den Druck auf eine der Tasten 12 ein bestimmter Menüpunkt, beispielsweise Navigation, ausgewählt werden, so dass die dann angezeigten Menüs ausschließlich diesem Kontext zugeordnet und mittels des Dreh-Drück-(Schiebe)-Stellers 13 anwählbar sind.

Um die Eingabe von Worten oder Wortfolgen zu vereinfachen, ist das beispielhaft auf der Oberseite des Dreh-Drück-(Schiebe)-Stellers 13 angeordnete Touch-Panel 11 vorgesehen. Diese Anordnung ist lediglich exemplarisch. Das Touch-Panel 11 könnte auch an anderer Stelle der Eingabevorrichtung 1 vorgesehen sein.

Über das Touch-Panel 11 kann in einer von Computern (insbesondere Notebooks und Netbook-Rechnern) bekannten Weise durch Berührung z.B. ein Cursor nach Art eines Mauszeigers auf dem Bildschirm navigiert werden. Ebenso kann das Touch-Panel 11 dazu ausgebildet sein, durch einen Benutzer vorgenommene Bewegungsfolgen oder mehrerer Finger zu detektieren, wodurch beispielsweise die direkte Eingabe von Buchstaben ermöglicht wird. Eine Anzeigefähigkeit von Informationen braucht es hierzu nicht besitzen.

In erfindungsgemäßer Weise weist das Touch-Panel 11 eine keramische Oberfläche auf. Entsprechend der Gestalt des Dreh-Drück-(Schiebe)-Stellers 13 weist das Touch-Panel 11 beispielhaft eine kreisrunde Gestalt auf. Durch in die Keramik eingelassene Pigmente kann die Oberfläche des Touch-Panels 11 eingefärbt sein. Produktionsbedingt ist es dabei möglich, unterschiedliche Uni-Farben herzustellen.

Die keramische Oberfläche des Touch-Panels 11 wird bevorzugt durch eine Keramik-Folie erzeugt. Solche Keramik-Folien sind als Grundmaterialien beispielsweise von den Herstellern CeramTec GmbH, Marktredwitz, H.C. Starck Ceramics GmbH & Co. KG, Selb, KERAFOL Keramische Folien GmbH, Eschenbach verfügbar. Vor dem Brennen der Keramikfolien sind diese verformbar, so dass das Touch-Panel z.B. mit einer gewölbten Oberfläche ausgebildet werden kann. Hierzu wird die Keramik-Folie zunächst in die spätere Grundform gebracht und zum Erhalt der Form beim Sintern bespielsweise auf ein Brennhilfsmittel abgelegt. Nach dem anschließenden Brennvorgang ist die Oberfläche spröde, jedoch fest und gegenüber Abnutzung und Abrieb überaus robust. Insbesondere ist es nicht notwendig, die keramische Oberfläche des Touch-Panels 11 mit einer weiteren Oberflächenbeschichtung zu versehen, wie dies im Gegensatz dazu bei Oberflächen aus Kunststoff notwenig ist. Es ist weder eine chemische noch eine physikalische Oberflächenbehandlung erforderlich.

Um die Oberfläche des Touch-Panels optimiert auszubilden, kann diese geschliffen, poliert, geätzt, gelasert oder sandgestrahlt werden. Beispielsweise kann hierdurch ein Aufrauhen der Oberfläche vorgenommen werden, um die Haptik und Oberflächeneigenschaften in gewünschter Weise zu gestalten.

Die aus der keramischen Folie gebildete keramische Oberfläche weist vorzugsweise eine Dicke zwischen 0,3 mm und 1,0 mm auf. In diesem Fall ist die Erkennung der Berührung durch einen Benutzer sowohl bei einer kapazitiven als auch bei einer auf Infrarot-Technik basierenden Sensierungstechnologie sichergestellt.

Die Oberflächenaufwertung und Darstellung der keramischen Folie kann beispielsweise direkt nach dem Brennprozess erfolgen. Insbesondere können Läpp- und Schleifprozesse durchgeführt werden, mit denen eine hohe Oberflächengüte erzeugbar ist. Eine Farbgebung könnte mit unterschiedlichen Beschichtungsprozessen, wie beispielsweise PVD-Beschichtungen, erfolgen. Darüber hinaus können Teilflächen der Oberfläche des Touch-Panels 11 durch Strahlen oder Laser mechanisch bearbeitet werden, um beispielsweise haptisch und taktil spürbare spezifische Strukturen zu schaffen.

Die keramische Oberfläche wird vorzugsweise aus den Hauptbestandteilen Zirkonoxid (ZrO₂) oder Aluminiumoxid (Al₂O₃) gefertigt, wobei Al₂O₃ aufgrund seiner sehr hohen Oberflächenhärte meist eine geringere Oberflächengüte im Vergleich zu ZrO₂ aufweist. Beide Materialien weisen jedoch gleichermaßen die insbesondere im Automobilbereich geforderten Lebensdauerzyklen auf, ohne dass eine optische und haptische Beeinträchtigung der Oberfläche des Touch-Panels 11 festgestellt werden könnte.

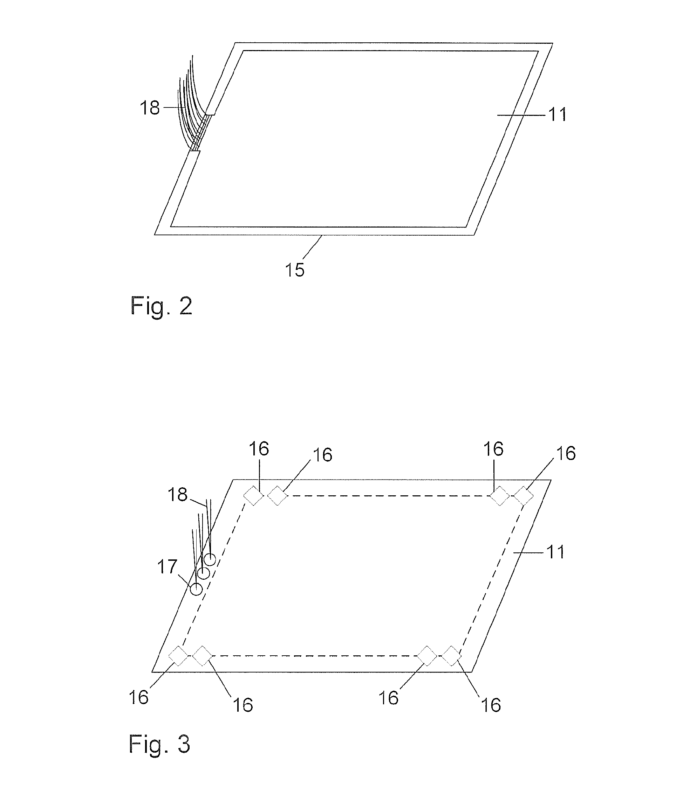

Die Figuren 2 und 3 zeigen zwei unterschiedliche Ausgestaltungsformen, auf welche Weise die keramischen Oberflächen des Touch-Panels 11 elektrisch kontaktiert werden können. In der in Fig. 2 gezeigten Ausführungsvariante wird nach Herstellung der keramischen Folie diese mit einer Sensorfolie 15, beispielsweise einer ITO-Folie, verbunden. Über einen elektrischen Leiter 18, z.B. einen Kabelstrang, wird die Sensorfolie 15 mit einer Recheneinheit zur Auswertung von durch Berührung erzeugten Steuerkommandos verbunden. Das in Fig. 2 dargestellte, lediglich exemplarisch ausgebildete rechteckige Halbzeug, kann dann als Eingabemittel in eine erfindungsgemäße Eingabevorrichtung eingebaut werden.

Unter Verwendung anderer Beschichtungsverfahren kann auf die ITO-Folientechnik verzichtet werden. In diesem Zusammenhang kann beispielsweise die Rückseite der Keramikfolie mittels PVD-Prozessen zunächst vollflächig beschichtet werden. Aus der vollflächigen Beschichtung wird eine leitende Sensorstruktur erzeugt, z.B. über ein subtraktives Verfahren zur Ausbildung entsprechender leitender Flächen. Beispielhaft sind in Fig. 3 nebeneinander, in einem regelmäßigen Raster angeordnete Rauten als leitende Struktur 16 dargestellt. Der Abgriff der Signale erfolgt über auf der Rückseite, d.h. der der Berührung abgewandten Seite der keramischen Folie vorgesehene Kontaktflächen 17 und entsprechend daran befestigte elektrische Leiter, wie z.B. Kabel.

Die erfindungsgemäß vorgeschlagenen Touch-Panels mit keramischer Oberfläche weisen nicht nur eine gegenüber Beanspruchung überaus hohe Widerstandsfähigkeit auf. Durch die zur Bearbeitung von keramischen Oberflächen zur Verfügung stehenden Verfahren lassen sich sehr hochwertig anmutende Oberflächen erzeugen. Durch mechanische Bearbeitungsverfahren kann die Oberfläche mit Mustern und/oder Markierungen versehen werden, die die Bedienung des Touch-Panels und die Orientierung erleichtern.

### Bezugszeichenliste

- 1: Eingabevorrichtung
- 10: Eingabemittel
- 11: Touch-Panel
- 12: Taste(n)
- 13: Dreh-Drück-Schiebe-Steller
- 14: Trägereinheit
- 15: Sensorfolie
- 16: leitende Struktur
- 17: Abgriff der leitenden Struktur
- 18: elektrischer Leiter (Kabel)

## Patentansprüche

1. Eingabevorrichtung (1) zur Steuerung eines elektronischen Geräts mit einem Touch-Panel (11) als zumindest ein Eingabemittel (10), **dadurch gekennzeichnet, dass** das Touch-Panel (11) eine keramische Oberfläche aufweist.

2. Eingabevorrichtung nach Anspruch 1, **dadurch gekennzeichnet, dass** das Touch-Panel (11) keine Anzeigefähigkeit besitzt.

3. Eingabevorrichtung nach Anspruch 1 oder 2, **dadurch gekennzeichnet, dass** die keramische Oberfläche des Touch-Panels (11) durch eine keramische Folie gebildet ist.

4. Eingabevorrichtung nach Anspruch 3, **dadurch gekennzeichnet, dass** die keramische Folie, insbesondere direkt, auf eine auf Berührung empfindliche Sensorfolie einer Trägereinheit (14) aufgebracht ist.

5. Eingabevorrichtung nach Anspruch 3, **dadurch gekennzeichnet, dass** auf die Rückseite der keramischen Folie eine elektrisch leitende Struktur direkt aufgebracht ist, welche gemäß vorgegebener sensorischer Anforderungen durch ein subtraktives Verfahren erzeugt ist.

6. Eingabevorrichtung nach einem der vorhergehenden Ansprüche, **dadurch gekennzeichnet, dass** die keramische Oberfläche (11) eine Wölbung aufweist.

7. Eingabevorrichtung nach einem der vorhergehenden Ansprüche, **dadurch gekennzeichnet, dass** die keramische Oberfläche (11) entlang ihres Außenumfangs zumindest abschnittsweise kreisförmig ist.

8. Eingabevorrichtung nach einem der vorhergehenden Ansprüche, **dadurch gekennzeichnet, dass** die keramische Oberfläche (11) eine Dicke zwischen 0,3 mm und 1,0 mm aufweist.

9. Eingabevorrichtung nach einem der vorhergehenden Ansprüche, **dadurch gekennzeichnet, dass** die keramische Oberfläche (11) die unmittelbare Berührfläche ist.

10. Eingabevorrichtung nach einem der vorhergehenden Ansprüche, **dadurch gekennzeichnet, dass** die keramische Oberfläche (11) einer mechanischen Oberflächenbehandlung, insbesondere einem Läpp-, Strahl- oder Schleifprozess oder einer Laser-Ablation, unterzogen ist.

11. Eingabevorrichtung nach einem der vorhergehenden Ansprüche, **dadurch gekennzeichnet, dass** die keramische Oberfläche (11) hauptsächlich aus Zirkonoxid oder aus Aluminiumoxid gebildet ist.

12. Eingabevorrichtung nach einem der vorhergehenden Ansprüche, **dadurch gekennzeichnet, dass** das Touch-Panel (11) ein Eingabemittel (10) einer zentralen Bedieneinheit eines Kraftfahrzeugs ist.

13. Eingabevorrichtung nach einem der vorhergehenden Ansprüche, **dadurch gekennzeichnet, dass** diese als weitere Eingabemittel (10) Tasten (12) und/oder einen Dreh-Drück-(Schiebe)-Steller (13) umfasst.

14. Eingabevorrichtung nach Anspruch 13, **dadurch gekennzeichnet, dass** das Touch-Panel (11) auf dem Dreh-Drück-(Schiebe)-Steller (13) ausgebildet ist.
